# EUROPEAN PATENT APPLICATION

(11) **EP 4 723 174 A1**
(43) Date of publication of application: **08.04.2026**
(21) Application number: 24810651.0
(22) Date of filing: 26.02.2024
(51) Int. Cl.: H01L 27/12, H01L 21/02, H01L 21/20, H01L 21/205, H01L 21/316

(54) **HIGH MOBILITY SUBSTRATE HAVING DELTA-DOPED LAYER AND METHOD FOR MANUFACTURING HIGH MOBILITY SUBSTRATE**

(30) Priority: 25.05.2023 JP 2023085935
(71) Applicant: Shin-Etsu Handotai Co., Ltd., Tokyo 100-0004 (JP)
(72) Inventor: OHTSUKI Tsuyoshi, Nishishirakawa-gun, Fukushima 961-8061 (JP); MATSUBARA Toshiki, Nishishirakawa-gun, Fukushima 961-8061 (JP); FUJII Kota, Nishishirakawa-gun, Fukushima 961-8061 (JP); ABE Tatsuo, Nishishirakawa-gun, Fukushima 961-8061 (JP); SUZUKI Atsushi, Nishishirakawa-gun, Fukushima 961-8061 (JP)
(74) Representative: Schicker, Silvia
(86) International application number: PCT/JP2024/006739
(87) International publication number: WO 2024/241643

(57) **Abstract**

There is provided a high mobility substrate according to the present invention, including: a semiconductor substrate; a first δ-doped layer over the semiconductor substrate, the first δ-doped layer having a larger bandgap than the semiconductor substrate; a thin film over the first δ-doped layer, the thin film being of the same material as that of the semiconductor substrate; and a second δ-doped layer over the thin film, the second δ-doped layer having a larger bandgap than the semiconductor substrate, in which the high mobility substrate has a structure in which the thin film is sandwiched between the first δ-doped layer and the second δ-doped layer. Thus, this provides: a practical high mobility substrate in which the high mobility structure can be uniformly formed over the entire surface of a large-area substrate with the high mobility being achieved; and a method for manufacturing the high mobility substrate.

## Description

### TECHNICAL FIELD

The present invention relates to a high mobility substrate having a δ-doped layer and a method for manufacturing a high mobility substrate.

### BACKGROUND ART

Two-dimensional materials such as MoS₂ are being extensively studied as more advanced generation channel materials for a FinFET (Fin Field Effect Transistor), which is currently in the mainstream, and a GAAFET (Gate All Around Field Effect Transistor), which is partially put into practice. This is because the advancement of miniaturization is reaching the limit of higher performance, and this technology is expected to achieve higher performance by using a high mobility material as the channel material.

Although, as to proposed two-dimensional materials known for MoS₂ above, graphene, BN, and the like, their significant characteristics have been proved, it is still difficult to obtain large-diameter films of them. Although Non-Patent Document 1 discloses an example of BN, it seems to show that film formation thereof has been achieved from the center to about a half on a silicon substrate with a diameter of 100 mm.

Moreover, one can easily think of more difficulty in pasting or fixing such a film onto a substrate due to a property of the material (that it exists stable as a two-dimensional thin film) than the difficulty in film formation, and in devices operations of which have been proved, the two-dimensional material seems to be fixed with the material of source and drain electrodes.

On the other hand, focusing on silicon materials, since the early days of SOI (Silicon on Insulator), improvement of mobility has been known with a structure in which thin silicon of about 2 to 3 nm is sandwiched between silicon oxide films, and the similar mobility to that of the two-dimensional material such as MoS₂ can be achieved (Non-Patent Documents 2 and 3).

Although, as mentioned above, the structure in which silicon is covered by (sandwiched between) insulating films can improve the mobility and achieve the similar mobility to that of the two-dimensional material, there is difficulty in making the structure uniform over the entire surface of a wafer, for example, over the entire surface of a substrate with a diameter of 300 mm. While a conventional technique is, first, to transfer a silicon layer onto an oxide film by pasting a wafer on which the oxide film is formed and a substrate in which H⁺ is implanted to peel off these, and afterward, to form an oxide film thereover, control of uniformity with a thickness of 2 to 3 nm over the entire surface of a diameter of 300 mm is difficult due to a problem of in-plane uniformity of oxide films (in-plane uniformity on a diameter of 300 mm in an oxidation furnace has to be 0.1 nm or less).

### CITATION LIST

### NON-PATENT LITERATURE

Non-Patent Document 1: ISSCC 2021.1.1, Mark Liu, "Unleashing the Future of Innovation"
Non-Patent Document 2: ISSCC 2023.27.3, D. Verrreck, et al., "The promise of 2-D materials for scaled digital and analog applications".
Non-Patent Document 3: Sumita, et al., "Optimum Channel Design of Extremely-Thin-Body nMOSFETs Utilizing Anisotropic Valley - Robust to Surface Roughness Scattering", The 70th JSAP Spring Meeting 2023, Proceedings: 16p-A403-2.

### SUMMARY OF INVENTION

### TECHNICAL PROBLEM

As above, even though it has been known that high mobility can be achieved by making silicon into a thin film and covering (sandwiching) it with (between) oxide films, it has been conventionally difficult to form them uniform over the entire surface of a substrate, and such formation has not been practical.

The present invention is devised in view of the aforementioned problem of the related art, and an object thereof is to provide a practical high mobility substrate in which the high mobility structure can be uniformly formed over the entire surface of a large-area substrate with the high mobility being achieved, and a method for manufacturing the high mobility substrate.

### SOLUTION TO PROBLEM

In order to solve the aforementioned problem, there is provided a high mobility substrate according to the present invention, comprising: a semiconductor substrate; a first δ-doped layer over the semiconductor substrate, the first δ-doped layer having a larger bandgap than the semiconductor substrate; a thin film over the first δ-doped layer, the thin film being of the same material as that of the semiconductor substrate; and a second δ-doped layer over the thin film, the second δ-doped layer having a larger bandgap than the semiconductor substrate, wherein the high mobility substrate has a structure in which the thin film is sandwiched between the first δ-doped layer and the second δ-doped layer.

With such a high mobility substrate, since the first δ-doped layer and the second δ-doped layer have larger bandgaps than the thin film, curvature of bands (also called band bending), which appears at the junction between a semiconductor and an insulator having a larger bandgap than the semiconductor, occurs at the junction interface between the thin film and each δ-doped layer, which forms a groove low in potential, and thereby, improves the mobility.

Moreover, since using the δ-doped layers allows interface roughness (coarseness) not to be large, the mobility is prevented from lowering due to interface scattering, and high mobility is maintained.

Furthermore, such δ-doped layers can be obtained by easy doping on a semiconductor substrate and thin films, and can be uniformly formed even over the entire surface of a large-area substrate, in particular, of a large-diameter substrate. Herein, the definition of δ-doping is that the doping results in a thin doped layer (for example, results in a layer of 3 nm or less).

Moreover, it is preferable that: the first δ-doped layer and the second δ-doped layer are δ-doped layers with oxygen; the semiconductor substrate and the thin film are of silicon; and the thin film has a thickness of 2 nm or more and 3 nm or less.

With such δ-doped layers with oxygen, since silicon oxide films SiO₂ as insulating films are formed over the silicon substrate and the silicon thin film to form a structure in which the thin silicon of 2 nm or more and 3 nm or less is sandwiched between the silicon oxide films, the mobility can be securely improved to be the similar mobility to that of the two-dimensional material such as MoS₂.

Moreover, there is provided a method for manufacturing a high mobility substrate according to the present invention, wherein: over a semiconductor substrate, a first δ-doped layer having a larger bandgap than the semiconductor substrate is formed; a thin film of the same material as that of the semiconductor substrate is formed over the first δ-doped layer; a second δ-doped layer having a larger bandgap than the semiconductor substrate is formed over the thin film; and the thin film is sandwiched between the first δ-doped layer and the second δ-doped layer.

With such a method for manufacturing a high mobility substrate, since the first δ-doped layer and the second δ-doped layer have the larger bandgaps than the thin film, curvature of bands (also called band bending), which appears at the junction between a semiconductor and an insulator having a larger bandgap than the semiconductor, occurs at the junction interface between the thin film and each δ-doped layer, which forms a groove low in potential, and thereby, can improve the mobility.

Moreover, since using the δ-doped layers allows interface roughness (coarseness) not to be large, the mobility is prevented from lowering due to interface scattering, and high mobility can be maintained.

Furthermore, such δ-doped layers can be obtained by easy doping on a semiconductor substrate and thin films, and can be uniformly formed even over the entire surface of a large-area substrate, in particular, of a large-diameter substrate.

Moreover, it is preferable that: the first δ-doped layer and the second δ-doped layer are δ-doped layers with oxygen; the semiconductor substrate and the thin film are of silicon; and the thin film has a thickness of 2 nm or more and 3 nm or less.

With such δ-doped layers with oxygen, since silicon oxide films SiO₂ as insulating films are formed over the silicon substrate and the silicon thin film to form a structure in which the thin silicon of 2 nm or more and 3 nm or less is sandwiched between the silicon oxide films, the mobility can be securely improved to be the similar mobility to that of the two-dimensional material such as MoS₂.

Moreover, it is preferable that: in forming the thin film, the thin film is formed in advance with a thickness a reduction of which due to oxidation is taken into account; and the second δ-doped layer is formed by oxidizing the thin film.

With such a method, the thin film can be prevented from being too thin, and can be securely formed to have a desired thickness.

Moreover, it is preferable that: over the first δ-doped layer, formation of silicon with a thickness of 1 nm or more and 3 nm or less and formation of a δ-doped layer with oxygen are repeated a plurality of times; and afterward, silicon for the thin film with a thickness of 2 nm or more and 3 nm or less is formed thereover.

With such a method, the high mobility substrate can be securely manufactured even to have a laminate structure.

### ADVANTAGEOUS EFFECTS OF INVENTION

With the high mobility substrate and the method for manufacturing a high mobility substrate of the present invention, the high mobility structure can be uniformly formed over the entire surface of a large-area substrate, in particular, of a large-diameter substrate with the high mobility being achieved, and is practical.

Moreover, using such a thin film layer imitating the two-dimensional material can form a high mobility channel material over the entire surface of a large-area substrate, in particular, of a large-diameter substrate.

Furthermore, such a thin film layer is inexpensive since it can be achieved with a general semiconductor material such as silicon not using the expensive two-dimensional material such as MoS₂.

### BRIEF DESCRIPTION OF DRAWINGS

[FIG. 1] is a schematic diagram of a high mobility substrate in a first embodiment of the present invention;
[FIG. 2] is a schematic diagram of a high mobility substrate in a second embodiment of the present invention; and
[FIG. 3] is a schematic diagram of a high mobility substrate in a third embodiment of the present invention.

### DESCRIPTION OF EMBODIMENT

Hereafter, while details of the present invention will be described, the present invention is not limited to these.

The inventors have intensively investigated the aforementioned problems to complete the present invention by finding a structure that includes: a semiconductor substrate; a first δ-doped layer over the semiconductor substrate, the first δ-doped layer having a larger bandgap than the semiconductor substrate; a thin film over the first δ-doped layer, the thin film being of the same material as that of the semiconductor substrate; and a second δ-doped layer over the thin film, the second δ-doped layer having a larger bandgap than the semiconductor substrate, wherein the thin film is sandwiched between the first δ-doped layer and the second δ-doped layer. Namely, specifically, by combination of δ-doping, laminating thin film silicon, and oxidation processing, a structure is formed in which the thin film silicon with a thickness of 2 nm or more and 3 nm or less is sandwiched between oxide films that are insulator as the δ-doped layers (more specifically, SiO₂ which is a material having a larger bandgap than silicon), it has been thereby found that a more inexpensive substrate high in quality is obtained not using the expensive two-dimensional material, and the present invention has been thus completed.

This can be achieved, for example, by δ-doping on a silicon substrate with oxygen atoms, further laminating thereover silicon with a thickness of 2 nm or more and 3 nm or less to form thin film silicon, and further δ-doping thereon with oxygen atoms.

Furthermore, this can also be provided by: δ-doping on a silicon substrate with oxygen atoms; further laminating thereover silicon in advance with a thickness a reduction of which due to oxidation is taken into account to form thin film silicon; and afterward performing the oxidation.

Furthermore, this can also be provided by: δ-doping on a silicon substrate with oxygen atoms; repeating a plurality of times laminating thereover silicon with a thickness of 1 nm or more and 3 nm or less, desirably, 1 nm and δ-doping thereon with oxygen atoms; afterword, further laminating thereover silicon with a thickness of 2 to 3 nm to form thin film silicon; and δ-doping thereon with oxygen atoms.

Hereafter, a first embodiment preferable for the present invention is described with reference to the drawings.

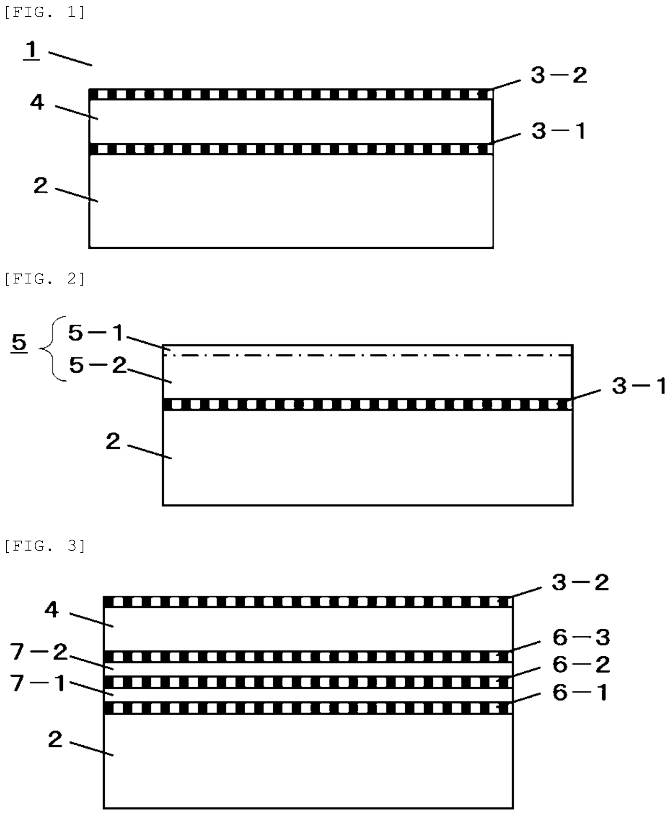

First, a configuration of a high mobility substrate 1 is described with reference to FIG. 1.

As shown in FIG. 1, the high mobility substrate 1 of the present embodiment includes: a semiconductor substrate (supporting substrate) 2; a first δ-doped layer (first oxide film layer) 3-1 over the semiconductor substrate 2, the first δ-doped layer (first oxide film layer) 3-1 having a larger bandgap than the semiconductor substrate 2; a thin film (silicon) 4 over the first δ-doped layer 3-1, the thin film (silicon) 4 being of the same material as that of the semiconductor substrate 2; and a second δ-doped layer (second oxide film layer) 3-2 over the thin film 4, the second δ-doped layer (second oxide film layer) 3-2 having a larger bandgap than the semiconductor substrate 2, and has a structure in which the thin film 4 is sandwiched between the first δ-doped layer 3-1 and the second δ-doped layer 3-2.

Herein, the first δ-doped layer 3-1 and the second δ-doped layer 3-2 are preferably δ-doped layers with oxygen, and form oxide films. Moreover, the semiconductor substrate 2 and the thin film 4 are of silicon, and have thicknesses of 2 nm or more and 3 nm or less in order to exhibit high mobility. In the case of 2 nm or more, the thin film (silicon) 4 layer tends to be a perfect crystal, which can improve mobility. Meanwhile, in the case of 3 nm or less, it has different characteristics from those of typical bulk silicon, which can improve the mobility more effectively. Hereafter, there is mainly described, as a preferable mode, a case where the semiconductor substrate 2 is a silicon substrate and the δ-doped layers are oxide film layers. Notably, in the case of doping with oxygen, δ-doping can be performed by thermal oxidation or natural oxidation.

With the high mobility substrate 1 of the present embodiment, since the first δ-doped layer 3-1 and the second δ-doped layer 3-2 have larger bandgaps than the thin film 4, curvature of bands (also called band bending), which appears at the junction between a semiconductor and an insulator having a larger bandgap than the semiconductor, occurs at the junction interface between the thin film 4 and each δ-doped layer, which forms a groove low in potential, and thereby, can improve the mobility.

Moreover, since using the δ-doped layers allows interface roughness (coarseness) not to be large, the mobility is prevented from lowering due to interface scattering, and high mobility is maintained.

Furthermore, such δ-doped layers can be obtained by easy doping on a semiconductor substrate and thin films, and can be uniformly formed even over the entire surface of a large-area substrate, in particular, of a large-diameter substrate.

With such δ-doped layers with oxygen (the first δ-doped layer 3-1 and the second δ-doped layer 3-2) of the present embodiment, since silicon oxide films SiO₂ as insulating films are formed over the silicon substrate (semiconductor substrate 2) and the silicon thin film (thin film 4) to form a structure in which the thin silicon (thin film 4) of 2 nm or more and 3 nm or less is sandwiched between the silicon oxide films, the mobility can be securely improved to be the similar mobility to that of the two-dimensional material such as MoS₂.

Next, a specific manufacturing flow of the high mobility substrate 1 of the present embodiment is described with reference to FIG. 1. The semiconductor substrate (supporting substrate) 2 is provided, which can be a general silicon substrate. In the case of a silicon substrate, while it preferably has the (100) orientation in view of electron mobility, it may be a (110) substrate in consideration of balance with hole mobility, and the plane orientation of the substrate can be selected according to the application thereof.

Next, over the semiconductor substrate (supporting substrate) 2, the first δ-doped layer (first oxide film layer) 3-1 with oxygen having a larger bandgap than the semiconductor substrate 2 is formed. With the method for forming the δ-doped layer over the semiconductor substrate 2, a δ-doped layer can be uniformly formed even over a large-diameter substrate such as a substrate with a diameter of 300 mm.

Here, although the method for forming the δ-doped layer is not specifically restricted, an oxygen concentration can be a concentration at which a silicon single crystal can be grown thereon, with further formation of the thin film (silicon) 4 thereover being taken into account, which is of the same material as that of the semiconductor substrate. In this case, the oxygen concentration is preferably about 1 × 10¹⁵ atoms/cm².

Next, the thin film (silicon) 4 layer of the same material as that of the semiconductor substrate 2 is grown on the first δ-doped layer 3-1. When a thin film with a thickness of 2 nm or more and 3 nm or less is grown, while the method of the growth is not specifically restricted, an apparatus that can employ the conditions of low temperature and reduced pressure can readily perform such growth.

Next, over the thin film 4, the second δ-doped layer (second oxide film layer) 3-2 with oxygen having a larger bandgap than the semiconductor substrate 2 is formed. The method for this may be the same as the method for forming the first δ-doped layer (first oxide film layer) 3-1.

As above, the thin film 4 can be sandwiched between the first δ-doped layer 3-1 and the second δ-doped layer 3-2, and the high mobility substrate 1 as in FIG. 1 can be manufactured.

With the method for manufacturing the high mobility substrate 1 of the present embodiment, since the first δ-doped layer 3-1 and the second δ-doped layer 3-2 have the larger bandgaps than the thin film 4, curvature of bands (also called band bending), which appears at the junction between a semiconductor and an insulator having a larger bandgap than the semiconductor, occurs at the junction interface between the thin film 4 and each δ-doped layer, which forms a groove low in potential, and thereby, can improve the mobility.

Moreover, since using the δ-doped layers allows interface roughness (coarseness) not to be large, the mobility is prevented from lowering due to interface scattering, and high mobility can be maintained.

Furthermore, such δ-doped layers can be obtained by easy doping on a semiconductor substrate and thin films, and can be uniformly formed even over the entire surface of a large-area substrate, in particular, of a large-diameter substrate.

With the δ-doped layers with oxygen (the first δ-doped layer 3-1 and the second δ-doped layer 3-2) of the present embodiment, since silicon oxide films SiO₂ as insulating films are formed over the silicon substrate (semiconductor substrate 2) and the silicon thin film (thin film 4) to form a structure in which the thin silicon (thin film 4) of 2 nm or more and 3 nm or less is sandwiched between the silicon oxide films, the mobility can be securely improved to be the similar mobility to that of the two-dimensional material such as MoS₂.

A second embodiment is described with reference to FIG. 2.

A method for manufacturing a high mobility substrate of the present embodiment is a method in which: in forming the thin film, the thin film is formed in advance with a thickness a reduction of which due to oxidation is taken into account; and the second δ-doped layer is formed by oxidizing the thin film.

FIG. 2 shows a state before oxidizing a thin film (silicon) 5, and the thin film (silicon) 5 has a portion 5-1 that is to be oxidized and to form a second δ-doped layer, and a portion 5-2 that is not oxidized to remain as a thin film (silicon). Further, in order to cause the portion 5-2 that is not oxidized to remain as a thin film (silicon) to have 2 nm or more and 3 nm or less, the thin film (silicon) 5 is grown in advance to be thicker than 2 nm or more and 3 nm or less. The method of the oxidation may be a method of thermal oxidation of the thin film 5.

Here, since, when silicon is oxidized to form an oxide film, about a half the oxide film is silicon (for example, for the oxide film of 100 Å, silicon of 44 Å is used), it can be determined, in consideration of such a rate, how thicker the thin film 5 is formed to be with a reduction in thickness being taken into account, and confirmation with preliminary experiments or the like is desirably performed for more accuracy.

With such a method, the portion 5-2 that is not oxidized to remain as a thin film (silicon) out of the thin film 5 can be prevented from being too thin below 2 nm or more and 3 nm or less, and can be securely formed to have a desired thickness.

A third embodiment is described with reference to FIG. 3.

A method for manufacturing a high mobility substrate of the present embodiment is a method in which: over the first δ-doped layer, formation of silicon with a thickness of 1 nm or more and 3 nm or less and formation of a δ-doped layer with oxygen are repeated a plurality of times; and afterward, silicon for the thin film with a thickness of 2 nm or more and 3 nm or less is formed thereover.

With reference to FIG. 3, over a first δ-doped layer 6-1 with oxygen, silicon 7-1 is formed to have a thickness of 1 nm or more and 3 nm or less; furthermore, a δ-doped layer 6-2 with oxygen is formed; furthermore, silicon 7-2 is formed to have a thickness of 1 nm or more and 3 nm or less; furthermore, a δ-doped layer 6-3 with oxygen is formed; and afterward, the thin film (silicon) 4 is formed thereover to have a thickness of 2 nm or more and 3 nm or less.

With such a method, the high mobility substrate can be securely manufactured even to have a laminate structure.

Here, repeating a plurality times the silicon and the δ-doped layer shows that the repeating can form a laminate structure. Meanwhile, a three- or four-layer structure of channels for obtaining a sufficient current value is supposed in a CFET (Complementary Field Effect Transistor) structure, which is anticipated to be achieved as a next generation transistor structure in the 2030s, and the present embodiment can be applied to such a laminate structure.

### EXAMPLES

Hereafter, the present invention is specifically described with examples, which do not limit the present invention.

### [Example 1]

In Example 1, the first embodiment is implemented, and the high mobility substrate as shown in FIG. 1 is manufactured as an example.

First, as the semiconductor substrate (supporting substrate) 2, a boron-doped p-type silicon (110) single crystal substrate with a diameter of 300 mm and a resistivity of 10 Ω·cm was provided. This was immersed in an aqueous hydrofluoric acid solution in 1% concentration for 3 minutes to remove a native oxide film once, and afterward, was left in ambient air (at a temperature of 23°C ± 1°C and a humidity of 39% ± 3%) for 3 hours thereby to form the first δ-doped layer 3-1 with oxygen. After that, this was placed in a reduced pressure epitaxial growth apparatus to grow the thin film (silicon) layer 4 for 60 seconds under the conditions of a temperature of 700°C, a pressure of 100 Torr, and monosilane at 1200 sccm. After that, this was taken out from the apparatus to be left in ambient air for 1 hour thereby to perform film deposition of the second δ-doped layer 3-2 with oxygen on the front surface side and to obtain the high mobility substrate 1.

For the high mobility substrate obtained here, the thicknesses of the first δ-doped layer, the thin film (silicon) layer, and the second δ-doped layer were 3 nm, and the mobility was 100 cm²/V·s.

### [Example 2]

Example 2 is an example different from Example 1 in that steps of forming δ-doped layers and silicon layers are added.

As the semiconductor substrate (supporting substrate), a boron-doped p-type silicon (110) single crystal substrate with a diameter of 300 mm and a resistivity of 10 Ω·cm was provided. This was immersed in an aqueous hydrofluoric acid solution in 1% concentration for 3 minutes to remove a native oxide film once, and afterward, was left in ambient air (at a temperature of 23°C ± 1°C and a humidity of 39% ± 3%) for 3 hours thereby to form the first δ-doped layer with oxygen. After that, this was placed in a reduced pressure epitaxial growth apparatus to grow a silicon layer for 2 seconds under the conditions of a temperature of 700°C, a pressure of 100 Torr, and monosilane at 1200 sccm. After that, this was taken out from the apparatus to be left in ambient air for 1 hour thereby to form a third δ-doped layer with oxygen, and afterward, was placed in the reduced pressure epitaxial growth apparatus to grow a silicon layer for 2 seconds under the conditions of a temperature of 700°C, a pressure of 100 Torr, and monosilane at 1200 sccm. After that, this was taken out from the apparatus to be left in ambient air for 1 hour thereby to perform film deposition of the second δ-doped layer with oxygen on the front surface side, and was placed in the reduced pressure epitaxial growth apparatus to grow a silicon layer for 2 seconds under the conditions of a temperature of 700°C, a pressure of 100 Torr, and monosilane at 1200 sccm and to obtain the high mobility substrate.

For the high mobility substrate obtained here, the thicknesses of the first δ-doped layer, the silicon layer, the third δ-doped layer, the thin film (silicon) layer, and the second δ-doped layer were each 3 nm, and the mobility was 100 cm²/V·s.

### [Example 3]

Example 3 is an example different from Example 1 in that steps of forming δ-doped layers and silicon layers are added, in the film deposition conditions, in that the second δ-doped layer is formed by thermal oxidation of the thin film (silicon) in a thermal processing furnace, and in others.

As the semiconductor substrate (supporting substrate), a boron-doped p-type silicon (110) single crystal substrate with a diameter of 300 mm and a resistivity of 10 Ω·cm was provided. This was immersed in an aqueous hydrofluoric acid solution in 1% concentration for 3 minutes to remove a native oxide film once, and afterward, was left in ambient air (at a temperature of 23°C ± 1°C and a humidity of 39% ± 3%) for 3 hours thereby to form the first δ-doped layer with oxygen. After that, this was placed in a reduced pressure epitaxial growth apparatus to grow a silicon layer for 2 seconds under the conditions of a temperature of 700°C, a pressure of 100 Torr, and monosilane at 1200 sccm. After that, this was taken out from the apparatus to be left in ambient air for 1 hour thereby to form the third δ-doped layer with oxygen, and afterward, was placed in the reduced pressure epitaxial growth apparatus to grow the thin film (silicon) layer for 120 seconds under the conditions of a temperature of 700°C, a pressure of 100 Torr, and monosilane at 1200 sccm. After that, this was taken out from the apparatus and placed in a thermal processing furnace to perform thermal processing in an oxygen atmosphere at 600°C for 5 minutes and thereby to perform film deposition of the second δ-doped layer with oxygen on the front surface side, affording the high mobility substrate.

For the high mobility substrate obtained here, the thicknesses of the first δ-doped layer, the silicon layer, the third δ-doped layer, the thin film (silicon) layer, and the second δ-doped layer were each 3 nm, and the mobility was 100 cm²/V·s.

The results above are discussed.

As to the mobility in particular, the mobility of MoS₂ as a conventional two-dimensional material is 50 to 100 cm²/V·s according to Non-Patent Document 3, the mobilities of the high mobility substrates obtained in Examples 1 to 3 were 100 cm²/V·s, and hence, Examples 1 to 3 achieved the mobilities comparable to that of the two-dimensional material.

The above has shown that, with the high mobility substrate and the method for manufacturing a high mobility substrate of the present invention, the high mobility structure can be practical and be uniformly formed over the entire surface of a large-area substrate (large-diameter substrate) with the high mobility being achieved.

Moreover, using such a thin film layer imitating the two-dimensional material can form a high mobility channel material over the entire surface of a large-area substrate.

Furthermore, such a thin film layer is inexpensive since it can be achieved with a general semiconductor material such as silicon not using the expensive two-dimensional material such as MoS₂.

The present description includes the following embodiments.
[1]: A high mobility substrate comprising:
   a semiconductor substrate;
   a first δ-doped layer over the semiconductor substrate, the first δ-doped layer having a larger bandgap than the semiconductor substrate;
   a thin film over the first δ-doped layer, the thin film being of the same material as that of the semiconductor substrate; and
   a second δ-doped layer over the thin film, the second δ-doped layer having a larger bandgap than the semiconductor substrate, wherein
   the high mobility substrate has a structure in which the thin film is sandwiched between the first δ-doped layer and the second δ-doped layer.
[2]: The high mobility substrate according to [1], wherein:
   the first δ-doped layer and the second δ-doped layer are δ-doped layers with oxygen;
   the semiconductor substrate and the thin film are of silicon; and
   the thin film has a thickness of 2 nm or more and 3 nm or less.
[3]: A method for manufacturing a high mobility substrate, wherein:
   over a semiconductor substrate,
   a first δ-doped layer having a larger bandgap than the semiconductor substrate is formed;
   a thin film of the same material as that of the semiconductor substrate is formed over the first δ-doped layer;
   a second δ-doped layer having a larger bandgap than the semiconductor substrate is formed over the thin film; and
   the thin film is sandwiched between the first δ-doped layer and the second δ-doped layer.
[4]: The method for manufacturing a high mobility substrate according to [3], wherein:
   the first δ-doped layer and the second δ-doped layer are δ-doped layers with oxygen;
   the semiconductor substrate and the thin film are of silicon; and
   the thin film has a thickness of 2 nm or more and 3 nm or less.
[5]: The method for manufacturing a high mobility substrate according to [3] or [4], wherein:
   in forming the thin film, the thin film is formed in advance with a thickness a reduction of which due to oxidation is taken into account; and
   the second δ-doped layer is formed by oxidizing the thin film.
[6]: The method for manufacturing a high mobility substrate according to any one of [3] to [5], wherein:
   over the first δ-doped layer,
   formation of silicon with a thickness of 1 nm or more and 3 nm or less and formation of a δ-doped layer with oxygen are repeated a plurality of times; and
   afterward, silicon for the thin film with a thickness of 2 nm or more and 3 nm or less is formed thereover.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A high mobility substrate comprising:
a semiconductor substrate;
a first δ-doped layer over the semiconductor substrate, the first δ-doped layer having a larger bandgap than the semiconductor substrate;
a thin film over the first δ-doped layer, the thin film being of the same material as that of the semiconductor substrate; and
a second δ-doped layer over the thin film, the second δ-doped layer having a larger bandgap than the semiconductor substrate, wherein
the high mobility substrate has a structure in which the thin film is sandwiched between the first δ-doped layer and the second δ-doped layer.

2. The high mobility substrate according to claim 1, wherein:
the first δ-doped layer and the second δ-doped layer are δ-doped layers with oxygen;
the semiconductor substrate and the thin film are of silicon; and
the thin film has a thickness of 2 nm or more and 3 nm or less.

3. A method for manufacturing a high mobility substrate, wherein:
over a semiconductor substrate,
a first δ-doped layer having a larger bandgap than the semiconductor substrate is formed;
a thin film of the same material as that of the semiconductor substrate is formed over the first δ-doped layer;
a second δ-doped layer having a larger bandgap than the semiconductor substrate is formed over the thin film; and
the thin film is sandwiched between the first δ-doped layer and the second δ-doped layer.

4. The method for manufacturing a high mobility substrate according to claim 3, wherein:
the first δ-doped layer and the second δ-doped layer are δ-doped layers with oxygen;
the semiconductor substrate and the thin film are of silicon; and
the thin film has a thickness of 2 nm or more and 3 nm or less.

5. The method for manufacturing a high mobility substrate according to claim 3, wherein:
in forming the thin film, the thin film is formed in advance with a thickness a reduction of which due to oxidation is taken into account; and
the second δ-doped layer is formed by oxidizing the thin film.

6. The method for manufacturing a high mobility substrate according to any one of claims 3 to 5,
wherein:
over the first δ-doped layer,
formation of silicon with a thickness of 1 nm or more and 3 nm or less and formation of a 6-doped layer with oxygen are repeated a plurality of times; and
afterward, silicon for the thin film with a thickness of 2 nm or more and 3 nm or less is formed thereover.
